# EUROPEAN PATENT APPLICATION

(11) **EP 0 873 908 A2**
(43) Date of publication of application: **28.10.1998**
(21) Application number: 98107415.6
(22) Date of filing: 23.04.1998
(51) Int. Cl.: B60Q 11/00

(54) **Current detecting resistor and car-borne unit**

(30) Priority: 25.04.1997 JP 123033/97
(71) Applicant: Niles Parts Co., Ltd., Tokyo 143 (JP)
(72) Inventor: Sueoka, Toshiaki, c/o Niles Parts Co., Ltd., Tokyo 143 (JP)
(74) Representative: Luderschmidt, Schüler & Partner GbR

(57) **Abstract**

In order to realize an economic car-borne unit with less parts by using a unitary body incorporating both a resistor portion for detecting the current in a load used in a flasher unit, for example, and a contact terminal portion exposed to the exterior or a unit for electrical connection to an external terminal, a current detecting resistor is stamped from a copper-nickel alloy plate. The current detecting resistor (2) includes, integrally, the contact terminal portion (21) and the resistor portion (22). The contact terminal portion (21) has the form of a flat male terminal exposed to the exterior of a flasher unit, for example, to engage with a female terminal on the part of a car for electrical connection therewith. As a result, a current in a load, such as flasher lamp, flows in the resistor portion (22), and a voltage drop proportional to the current occurs across the opposite ends of the resistor portion.

## Description

### BACKGROUND OF THE INVENTION

### Field of the Invention

This invention relates to a current detecting resistor and a car-borne unit suitable for detecting an electric current flowing through a load, or the like, mounted on a vehicle.

### Description of the Related Art

A current detecting resistor is an element causing a voltage drop proportional to an electric current flowing though a load. It has been used as means for detecting breakage, short circuiting, or other accidents of a turn signal lamp mounted on a car, for example, by converting an electric current flowing in the turn signal lamp into a voltage value and by comparing the voltage value with a reference value in a comparator circuit. For example, Japanese Utility Model Laid-Open Publication No. 59-98553 (1984) discloses a car flasher using such a current detecting resistor having one end welded to a terminal (contact terminal portion) extending to the exterior of a unit, an intermediate point welded to a yoke of a relay and the opposite end connected to a printed wiring board. Current detecting resistors must satisfy some conditions, namely, having a small temperature coefficient, for example, to minimize errors in resistance value during the manufacturing process to ensure highly accurate detection of an electric current, promising a voltage drop as large as 0.1 V, for example, to minimize adverse affection to the load and spontaneous heating, using a material readily welded to ensure easy connection of the resistor to a circuit board packaging electric elements, and an additional condition, namely, that the current detecting resistor itself be economic when incorporated into a car-borne unit for which a serious cost reduction is requested.

However, current detecting resistors have conventionally been available as independent parts. Therefore, current detecting resistors, such as those disclosed by Japanese Utility Model Laid-Open Publication No. 59-98553 (1984), for example, involve various disadvantages, such as the need for a manufacturing process to weld and bond it to a terminal (contact terminal portion) externally extending from a unit, a liability of causing errors in resistance value depending on the welded status, the need for individually managing respective parts, namely, terminals (contact terminal portions) and current detecting resistors, and a high cost of the current detecting resistor prepared as an independent part.

### OBJECTS AND SUMMARY OF THE INVENTION

It is therefore an object of the invention to provide a current detecting resistor and a car-borne unit containing a current detecting resistor, which do not need the step of welding the resistor to a contact terminal portion, remove errors in resistance value caused by welding, and alleviate management of parts.

According to the invention, there is provided a current detecting resistor integrally incorporating a contact terminal portion to be connected to another terminal and a resistor portion causing a voltage drop proportional to a current flowing through said contact terminal portion.

The contact terminal portion may be configured as a flat male terminal.

Both the contact terminal portion and the resistor portion may be configured flat.

Fixing means may be formed at least between the contact terminal portion and the resistor portion to facilitate fixture of the current detecting resistor onto a circuit board.

The contact terminal portion and the resistor portion may be made of a copper-nickel alloy.

According to the invention, there is further provided a car-borne unit comprising a current detecting resistor integrally incorporating a contact terminal portion to be connected to another terminal and a resistor portion causing a voltage drop proportional to a current flowing through the contact terminal portion,
the contact terminal portion being exposed to the exterior of the unit and connected to a conductive path of a load mounted on a car, and a flow in the load being introduced into the resistor portion.

The car-borne unit may contain an electric element connected to opposite ends of the resistor portion to execute an electrical processing responsive to a voltage drop across the opposite ends of the resistor portion.

The car-borne unit may be a flasher unit connected to a turn signal lamp to control the flashing action of the turn signal lamp in response to a voltage drop across opposite ends of the resistor portion.

### BRIEF DESCRIPTION OF THE DRAWINGS

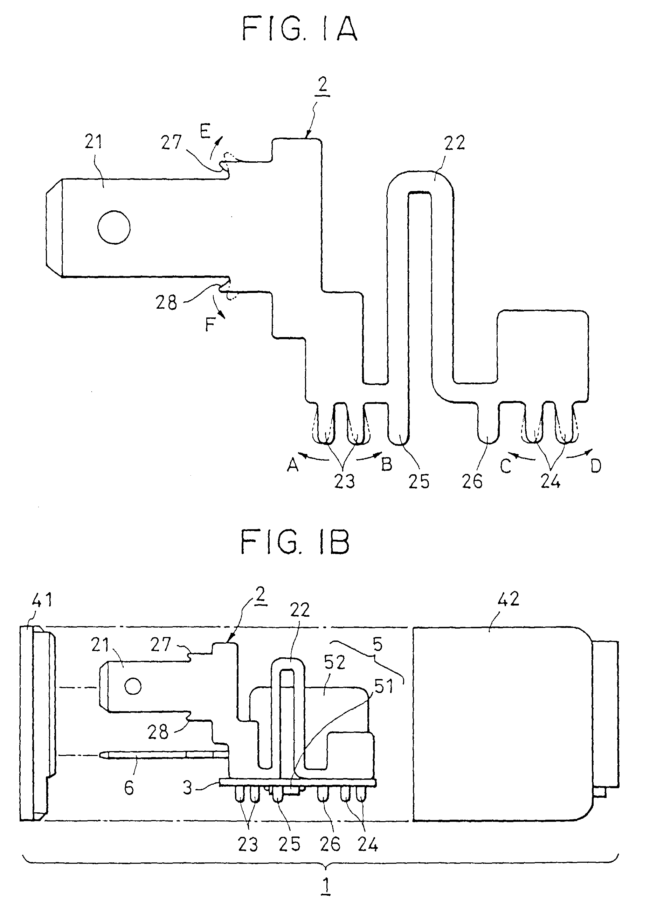

Fig. 1B is a side elevation of a current detecting resistor according to an embodiment of the invention;
Fig. 1B is an exploded view of a flash unit incorporating the current detecting resistor;
Fig. 2A is a top view of the flash unit shown in Fig. 1B before a case is mounted;
Fig. 2B is a side elevation of the flash unit, taken from the direction of the arrow G in Fig. 2A;
Fig. 2C is a side elevation of the flash unit after the case is mounted from the direction of the arrow H in Fig. 2B; and
Fig. 3 is an electric circuit diagram of the flash unit shown in Fig. 1 connected in an electrical conduction path of a turn signal lamp.

### DETAILED DESCRIPTION OF THE PREFERRED EMBODIMENTS

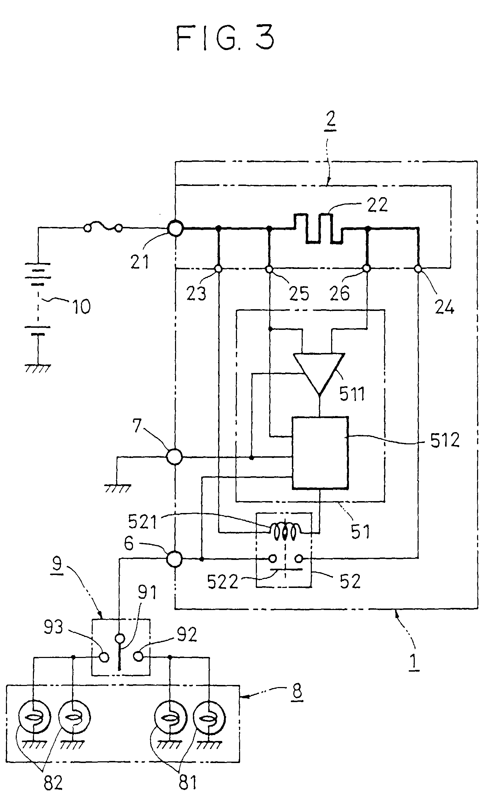

Figs. 1A through 2C show a current detecting resistor 2 and a flash unit 1 containing the current detecting resistor 2. Fig. 3 is an exemplary electrical circuit diagram of a car including the flash unit 1 and a turn signal lamp 8. The flash unit 1 is a unit for controlling the flashing action of the turn signal lamp 8 explained later, and incorporates the current detecting resistor 2 for converting the value of a current flowing in the turn signal lamp 8 into a voltage value.

As shown in Fig. 1A, the current detecting resistor 2 is an integral body including a contact terminal portion 21 for electrical contact with an other terminal, and a resistor portion 22 which causes a voltage drop proportional to a current flowing through the contact terminal portion 21. The other terminal, mentioned above, may be a plug receptacle (not shown) caulked to an end of a harness (not shown) wired from a d.c. supply 10 shown in Fig. 3. The contact portion 21 is configured as a flat male terminal suitable for engagement with the plug receptacle for electrical connection therewith. Namely, both the contact terminal portion 21 and the resistor portion 22 have configurations of flat plates.

The current detecting resistor 2 includes fixture portions 23, 24 between the contact terminal portion 21 and the resistor portion 22 and at the other end of the resistor portion 22 for fixing the current detecting resistor to a circuit board 3. The current detecting resistor 2 further includes output portions 25, 26 at opposite ends of the resistor portion 22 to deliver to an electric element 5 a signal indicating a voltage drop in the resistor portion 22. Additionally, the current detecting resistor 2 includes a pair of projections 27, 28 at roots of the contact terminal portion 21 to caulk it to a base 41 which is combined with a case 42 to form a housing of the flash unit 1.

The current detecting resistor 2 is made by pressing a copper-nickel (Cu-Ni) alloy plate. That is, both the contact terminal portion 21 and the resistor portion 22 are made of the copper-nickel alloy. The temperature coefficient of the copper-nickel alloy can be decreased to 100 (ppm/deg) or less, for example, by adjusting the composition ratio among copper, nickel and other elements.

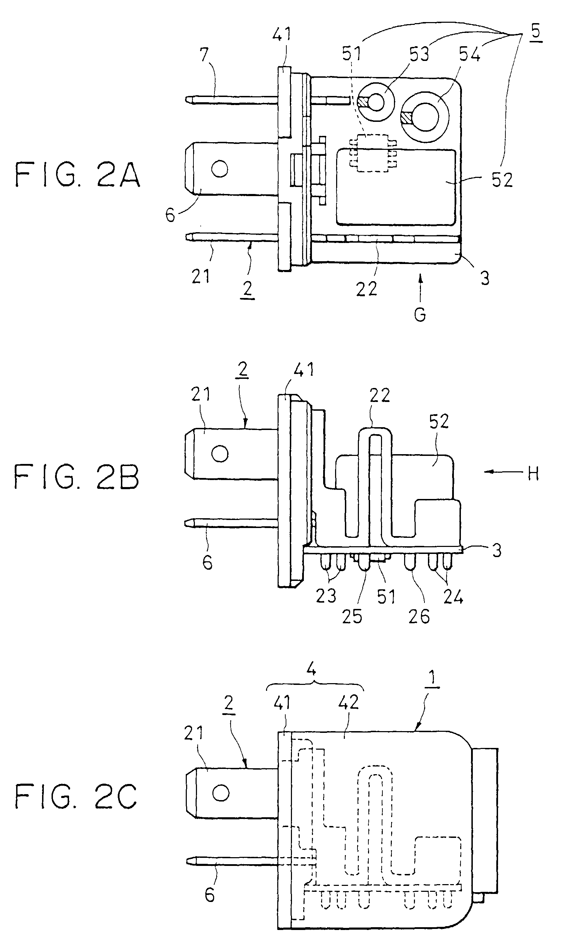

Next explained is a flash unit 1 incorporating the current detecting resistor 2. The flash unit 1 has a generally box-shaped unit, as shown in Fig. 2C, containing a circuit board 3, an electric element 5 packaged on the circuit board 3 and the resistor portion 22 of the current detecting resistor 2 within the housing defined by the base 41 and the case 42, and having the contact terminal portion 21 of the current detecting resistor 2 and other contact terminal portions 6, 7 extending externally of the housing. Similarly to the contact terminal portion 21 of the current detecting resistor 2, the contact terminals 6, 7 are flat-shaped male terminals suitable for engagement with the plug receptacles caulked to and end of a harness (not shown) wired from a turn signal switch 9, for example, shown in Fig. 3, and an end of a harness (not shown) wired from the ground connection of a car for electrical connection therewith.

Explained below in detail is the construction of the flash unit 1 containing the circuit board 3, electric element 5 and resistor portion 22. The circuit board 3 has a predetermined conductive pattern made of a copper foil on the lower surface of an insulating substrate. The current detecting resistor 2 is fixed to the circuit board 3 by inserting the fixture portions 23, 24 and output portions 25, 26 downward through the circuit board 3 and by bending the fixture portions 23, 24 in directions shown by arrows A, B, C and D in Fig. 1A under the circuit board 3.

A relay 52, capacitors 53, 54, etc. as electric elements 5 are packaged on the upper surface of the circuit board 3, an integrated circuit 51, etc. as electric elements are packaged on the back surface of the circuit board 3, and they are welded to the conductive pattern of the circuit board 3 together with the fixture portions 23, 24 and output portions 25, 26 of the current detecting resistor 2. After welding, by plugging the contact terminal portion 21 of the current detecting resistor 2 and other terminal portions 6 and 7 into holes (not shown) formed in the base 41, then caulking the projections 27 and 28 of the contact terminal portion 21 of the current detecting resistor 2 in directions shown by arrows E and F in Fig. 1A, and caulking similar projections (not shown) of the other contact terminal portions 6 and 7, the circuit board 3 packaging these elements is fixed to the base 41.

Next explained is the integrated circuit 51. The integrated circuit 51 is used exclusively for controlling the flashing action of the turn signal lamp 8, and generally includes a comparator circuit portion 511 and an oscillating circuit portion 512. More specifically, the comparator circuit portion 511 is supplied with a voltage value entering from the resistor portion 22 of the current detecting resistor through its output portions 25, 26, and compares it with a reference value to detect any accidental breakage or short-circuiting of the turn signal lamp 8 and to deliver a corresponding signal to the oscillating circuit portion 512. The oscillating circuit 512 has a breakage responsive function for increasing the flashing cycle of the turn signal lamp 8 upon receipt of a breakage detection signal from the comparator circuit portion 511, a short-circuit responsive function for decreasing the ON duty ratio of the flashing period of the turn signal lamp 8 to limit the power and to prevent the conductive path to the turn signal switch 9 from burning out when a short-circuit detection signal is received, and a start function for flashing the turn signal lamp 8 when it receives the potential of the contact terminal portion 6 upon the turn signal switch 9 being operated to the right or left direction. The third start function is next explained in greater detail. The oscillating circuit portion 512 includes a dividing circuit (not shown) for dividing the output potential of the d.c. source 10 by a resistance when the contact terminal portion 6 is electrically floating so chat the oscillating circuit portion 512 outputs no breakage signal when the potential at the contact terminal portion 6 is the divisional potential from the dividing circuit, but outputs a breakage signal when the potential at the contact terminal portion 6 substantially restores the ground potential or the power supply potential upon the turn signal switch 9 being operated to the right or left direction.

Connected to the output portion of the oscillating circuit portion 512 is a coil 521 of the relay 52 which is excited by intermittent pulses output from the oscillating circuit portion 512 for its respective functions to connect or disconnect the contact 522. The contact 522 of the relay 52 is connected to the turn signal switch 9 via the contact terminal portion 6 of the flasher unit 1. The turn signal switch 9 is a lever-operated switch attached to a steering column at the driver's seat of a car, and includes a movable contact 91 connected to the flasher unit 1, a right-side fixed contact 92 connected to a right-side lamp 81 of the turn signal lamp 8 for right-turn indication, and a left-side fixed contact 93 connected to the left-side lamp 82 for left-turn indication.

Next explained are operations of the above-explained embodiment with reference to Fig. 3. When the turn signal switch 9 is clicked to the right-turn direction, for example, the movable contact 91 is connected to the right-side fixed contact 92. Since the potential of the contact terminal portion 6 is changed to the ground potential immediately upon the turn signal switch 9 being operated, the oscillating circuit portion 512 of the integrated circuit 51 begins supplying an intermittent signal to the relay 52. In receipt of the intermittent signal, the relay 52 opens and shuts the contact 522. When the contact is opened, the potential of the contact terminal portion 6 becomes the ground potential approximately, and the oscillating circuit portion 512 therefore continues to output the intermittent signal to the relay 52. As a result, when the turn signal switch 9 is clicked to the right-turn direction, for example, the right-side lamp 81 of the turn signal lamp 8 flashes in response to the intermittent signal issued from the oscillating circuit portion 512. Also when the turn signal switch 9 is clicked to the left-turn direction, for example, the left-side lamp 82 of the turn signal lamp 8 similarly flashes in response to the intermittent signal from the oscillating circuit portion 512.

Explanation is made on operations of the circuit when one or more of right-side lamps 81 is broken when the turn signal switch 9 is clicked to the right-turn direction. Although the flashing current for the right-side lamp 81 flows in the resistor portion 22 of the current detecting resistor, the voltage value across the opposite ends of the resistor portion becomes smaller than the breakage reference value due to the disconnection in the right lamp 81, and the comparator circuit portion 511 issues a breakage detection signal to the oscillating circuit portion 512. Then, the comparator circuit portion 511 is activated for its breakage responsive function, and changes the intermittent cycle of the signal to the relay 52 to speed up the flashing cycle of the turn signal lamp 8. Thus, a crew of the car is informed of the breakage, or at least the abnormal condition, in the right-side lamp 81. Also when any breakage occurs in the left-side lamp 82, the circuit operates in substantially the same manner.

Next explained are operations of the circuit when the conductive path to the right-side lamp 81 is short-circuited upon the turn signal switch 9 being clicked to the right-turn side. In this case, a much more current flows in the resistor portion 22 than in the ordinary condition, and the voltage value across the opposite ends of the resistor portion 22 becomes larger than the short-circuit reference value. Thus, the comparator circuit portion 511 issued a short-circuit detection signal to the oscillating circuit portion 512. Then, the comparator circuit portion 511 is activated for its short-circuit responsive function, and changes the intermittent cycle of the signal to the relay 52 to decrease the ON duty ratio of the flashing period of the turn signal lamp 8 in order to limit the power and prevent the conductive path to the turn signal switch 9 from burning out. At the same time, the circuit informs the crew of the car of the short-circuit or, at least, the abnormal condition. Also when the conductive path to the left-side lamp 82 is short-circuited, the circuit operates in substantially the same manner.

The embodiment has been explained as using the contact terminal portion 21 of the current detecting resistor 2 configured as a flat male terminal, shaping the contact terminal portion 21 and the resistor portion 22 as flat plates on a common plane, using the fixture portion 23 at least between the contact terminal portion 21 and the resistor portion 22 to fix the current detecting resistor 2 to the circuit board 3, and making the contact terminal portion 21 and the resistor portion 22 of a copper-nickel alloy. However, the current detecting resistor 2 may be modified appropriately without departing the spirit and scope of the invention provided that it integrally includes both the contact terminal portion 21 for electrical connection with an external terminal and the resistor portion 22 for causing a voltage drop responsive to the current flowing in the contact terminal portion 21.

The car-borne unit containing the current detecting resistor 2 may be any unit, other than the flasher unit, such as power window unit, power seat unit, antenna control unit for extending or contracting an antenna, lamp breakage detecting unit, and so on. When it is used as a power window unit, the circuit may be configured to flow the current of a power window motor into the current detecting resistor 2 so that any accident, such as jamming a substance at the window, be known by detecting a lock current. If it is used as a power seat unit, then the circuit may be configured to flow the current of a power seat motor so that the maximum controllable position of a seat be known by detecting a lock current, or a ripple current, flowing in the power seat motor.

As described above, according to the invention, since the current detecting resistor integrally includes the contact terminal portion for electrical connection with another terminal and the resistor portion for causing a voltage drop proportional to the current flowing through the contact terminal portion, the manufacturing process needs not step for welding and joining the contact terminal portion and the resistor portion, and, due to no welding portion which is likely to cause errors in resistance value of the resistor portion, variance among products in resistance value in the resistor portion can be reduced. Additionally, because both the contact terminal portion and the resistor portion are incorporated into a single body, management on parts is alleviated, and these factors contribute to a cost reduction.

When the contact terminal portion of the current detecting resistor has the form of a flat male terminal, it fits the terminal of a flasher unit in accordance with a standard in the field of vehicles.

When the contact terminal portion and the resistor portion of the current detecting resistor are flat plates extending on a common plane, the current detecting resistor can be stamped using a simple-shaped die.

When the current detecting resistor has at least one fixture portion between the contact terminal portion and the resistor portion to fix the resistor to a circuit board, the current detecting resistor can be readily fixed to the circuit board.

When the current detecting resistor integrally including the contact terminal portion and the resistor portion of the current detecting resistor is made of a copper-nickel alloy, the temperature coefficient of the resistor portion can be decreases as remarkably small as 100 (ppm/deg) or less, for example, and so-called drift phenomenon, in which the resistance value fluctuates with its own heat or an external temperature, is unlikely to occur, and welding to the circuit board or other elements is made easier. Moreover, corrosion of the contact terminal portion can be prevented without the need for particular surface treatment thereof, and the reliability required for a terminal can be maintained for a long time.

The car-borne unit according to the invention includes the current detecting resistor integrally including both the contact terminal portion for electrical connection to another terminal and the resistor portion for causing a voltage drop proportional to the current flowing through the contact terminal portion, and introduces a part of the contact terminal portion to the exterior of the unit to connect to the conductive path of a load mounted on the car such that the current in the load flows into the resistor portion. Therefore, the unit does not require welding connection that is one of causes of errors in resistance value of the resistor portion, and hence alleviates errors in resistance value of the resistor portion. That is, the car-borne unit can detect the current flowing in a load with a high accuracy, and facilitates management of parts of the car-borne unit. These factors contribute to a reduction of the production cost.

When the car-borne unit includes electric elements connected to opposite ends of the resistor portion and contained in the unit to execute processing responsive to a voltage drop across the opposite ends of the resistor portion, external noises are unlikely to ride on voltage signals generated at opposite ends of the resistor portion.

When the car-borne unit is connected to a turn signal lamp, as a load, to function as a flasher unit for controlling the flashing action of the turn signal lamp in response to a voltage drop across opposite ends of the resistor portion, an economic flasher unit with less parts can be provided.

## Claims

1. A current detecting resistor integrally incorporating a contact terminal portion to be connected to another terminal and a resistor portion causing a voltage drop proportional to a current flowing through said contact terminal portion.

2. The current detecting resistor according to claim 1 wherein said contact terminal portion has the form of a flat male terminal.

3. The current detecting resistor according to claim 1 or 2 wherein said contact terminal portion and said resistor portion extend flat on a common plane.

4. The current detecting resistor according to claim 1, 2 or 3 wherein fixing means is provided at least between said contact terminal portion and said resistor portion.

5. The current detecting resistor according to claim 1, 2, 3 or 4 wherein said contact terminal portion and said resistor portion are made of a copper-nickel alloy.

6. A car-borne unit comprising:
a current detecting resistor integrally incorporating a contact terminal portion to be connected to another terminal and a resistor portion causing a voltage drop proportional to a current flowing through said contact terminal portion,
said contact terminal portion being exposed to the exterior of said unit and connected to a conductive path of a load mounted on a car, and a flow in said load being introduced into said resistor portion.

7. The car-borne unit according to claim 6 wherein said unit contains an electronic element connected to opposite ends of said resistor portion to execute processing responsive to a voltage drop across the opposite ends of said resistor.

8. The car-borne unit according to claim 6 or 7 wherein said unit is a flasher unit connected to a turn signal lamp as a load to control the flashing action of said turn signal lamp in response to a voltage drop across the opposite ends of said resistor portion.
